**Europäisches Patentamt**

**European Patent Office**

**Office européen des brevets**

(19)

(11) Veröffentlichungsnummer: **0 108 299**
**B1**

(12) # EUROPÄISCHE PATENTSCHRIFT

(45) Veröffentlichungstag der Patentschrift:
29.03.89

(51) Int. Cl.⁴: **H 01 S 3/097**

(21) Anmeldenummer: 83110383.3

(22) Anmeldetag: 18.10.83

(54) **Anregungssystem zur Erzeugung einer schnellen, gepulsten Hochspannungsentladung, insbesondere zur Anregung eines Hochleistungslasers.**

(30) Priorität: 02.11.82 DE 3240372

(43) Veröffentlichungstag der Anmeldung:
16.05.84 Patentblatt 84/20

(45) Bekanntmachung des Hinweises auf die Patenterteilung:
29.03.89 Patentblatt 89/13

(84) Benannte Vertragsstaaten:
AT CH DE FR GB IT LI

(56) Entgegenhaltungen:
EP-A-0 024 576

**IEEE JOURNAL OF QUANTUM ELECTRONICS,**
Band QE-17, Nr. 1, Januar 1981, Seiten 81-91, IEEE,
New York, US; R.C. SZE et al.: "Operating
characteristics of a high repetition rate miniature
rare-gas halide laser"

(73) Patentinhaber: **Siemens Aktiengesellschaft, Berlin
und München Wittelsbacherplatz 2, D-8000
München 2 (DE)**

(72) Erfinder: **Cirkel, Hans- Jürgen, Dr.,
Anderlohrstrasse 9, D-8520 Erlangen (DE)**
Erfinder: **Bette, Willi, Pappelgasse 7c, D-8520
Erlangen (DE)**

EP 0 108 299 B1

## Beschreibung

Die Erfindung bezieht sich auf ein Anregungssystem zur Erzeugung einer schnellen, gepulsten Hochspannungsentladung in einem Laser, insbesondere Hochleistungslaser, durch möglichst homogene, lichtbogenfreie Kondensatorentladung, gemäß Oberbegriff des Anspruchs 1.

Ein solches Anregungssystem ist durch die DE-OS-2 932 781 bekannt. Die dabei bevorzugt verwendeten TE-Laser (TE = transversely excited) haben aufgrund ihrer hohen Spitzenleistungen und hohen Impulsenergien besondere Bedeutung erlangt. Bei diesen Lasern wird das im Vergleich zu den longitudinal angeregten Gaslasern unter hohen Drucken (50 mbar bis mehrere bar) stehende Lasergas durch eine homogene elektrische Entladung bei mehreren kV über zwei ausgedehnte Elektroden angeregt, die, sich gegenüberliegend, parallel zur optischen Achse - der Emissionsrichtung des Lasers - angebracht sind. Über weitere Einzelheiten vergleiche die genannte DE-OS.

Geeignete Vorionisierungseinrichtungen für das Anregungssystem gemäß Gattungsbegriff sind insbesondere beschrieben in der DE-OS-3 035 730 und der DE-OS-3 035 702. Hier wie im folgenden wird vorausgesetzt, daß Anregungssysteme, so wie im Oberbegriff definiert, mit Vorionisierungs-Einrichtungen ausgerüstet sind; deswegen erübrigt sich eine Darstellung im Rahmen der vorliegenden Anmeldung.

Das Anregungssystem der eingangs definierten Art bezieht sich, wie erwähnt, vorzugsweise auf TE-Laser, wie z. B. $CO_2$-Laser oder Excimer-Laser, welche Lichtquellen darstellen, die - wie bereits angedeutet - wegen ihres hohen Wirkungsgrades und ihrer hohen Ausgangsenergie pro Puls in zahlreichen technischen Anwendungen zum Einsatz gelangen. Bei diesen gepulsten Systemen wird angestrebt, elektrische Energien in der Größenordnung von einem Kilojoule bei Wiederholraten von ungefähr 1 kHz in Bruchteilen einer Mikrosekunde zu schalten. Als Schalter für hohe Spannungen und hohe Ströme mit den für die genannten Lasersysteme erforderlichen kurzen Schaltzeiten kommen Funkenstrecken und Thyratrons zum Einsatz. Es sind bisher noch keine technischen Ausführungen dieser Schaltelemente bekannt, die die an sie gestellten hohen Anforderungen bei gleichzeitig hoher Standzeit erfüllen.

Nun sind aus der Radartechnik schon seit Beginn der 50er Jahre Schaltelemente bekannt, die aus sättigbaren Induktoren aufgebaut sind (Melville: "The use of Saturable Reactors as Discharge Devices for Pulse Generators", Proceedings IEE, London, 1951, Vol. 98, Part 3, 185 - 207). Die sättigbaren Induktoren werden eingesetzt, um hohe Ströme bei hohen Stromanstiegsgeschwindigkeiten zu schalten. Sie weisen eine rein metallische Stromleitung auf, die nicht den Verschleißmechanismen unterworfen ist, wie sie bei Funkenstrecken und Thyratrons auftreten. Der Einsatz von sättigbaren magnetischen Induktoren bietet somit Vorteile bei technischen Anwendungen, bei denen eine hohe Standzeit gefordert wird.

Über Herstellung, Zusammensetzung und Eigenschaften des ferromagnetischen Kernmaterials für derartige Induktoren ("metallisches Glas") ist z. B. berichtet in der Zeitschrift "SCIENTIFIC AMERICAN", April 1980, 84 bis 96, vergleiche auch US-PS-4 275 317.

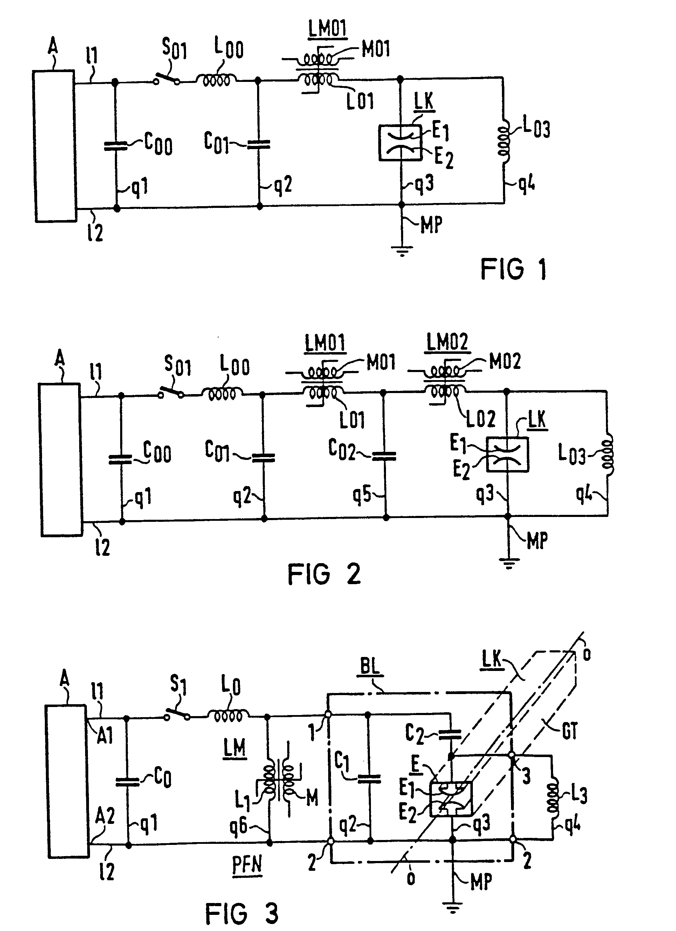

Durch die genannte US-PS-4 275 317 ist es bekannt, sättigbare Induktoren in einem speziellen pulsformenden Netzwerk, das zur Anregung von TE-Lasern geeignet ist, einzusetzen. Wie es weiter unten anhand von Fig. 1 und Fig. 2 noch näher erläutert wird, ist es bei diesem bekannten pulsformenden Netzwerk von Nachteil, daß der gesamte Laserstrom und damit die gesamte im Laser umgesetzte Energie durch den mit der Laserkammer in Reihe geschalteten sättigbaren Induktor fließen muß, der insbesondere bei hohen zu schaltenden elektrischen Energien eine beträchtliche Restinduktivität im gesättigten Zustand behält. Diese Restinduktivität erhöht erheblich die Impedanz des Laserentladungskreises im Vergleich zu einem solchen Kreis, der nur aus der Laserkammer und dem Ladekondensator aufgebaut ist. Für eine effektive Anregung des Lasergases erweist sich eine hohe Impedanz als schädlich.

Aufgabe der Erfindung ist es, die geschilderten Schwierigkeiten zu umgehen und ein Anregungssystem zur Erzeugung einer schnellen, gepulsten Hochspannungsentladung in einem Laser, insbesondere Hochleistungslaser, anzugeben, bei welchem eine Reihenschaltung des sättigbaren, magnetischen Induktors mit der Elektroden-Strecke des Lasers vermieden ist. Zur Lösung dieser Aufgabe geht die Erfindung zunächst aus von dem bekannten Anregungssystem gemäß Oberbegriff, wie es in der DE-OS-2 932 781 beschrieben ist, und bildet dieses Anregungssystem gemäß Kennzeichen des Anspruchs 1 durch die Maßnahmen weiter, daß das schnelle (nun in einem Querzweig liegende) Hochspannungs-Schaltelement als sättigbarer magnetischer Induktor ausgebildet ist, dessen Magnetisierungsstrom den Induktor in Sättigung gehen läßt, wenn die Ladespannung an den Bandleiter-Kondensatoren in den Bereich ihres Scheitelwertes gelangt ist.

Vorteilhafte Weiterbildungen sind in den Ansprüchen 2 bis 16 angegeben.

Die mit der Erfindung erzielbaren Vorteile sind vor allem darin zu sehen, daß erst jetzt der sättigbare magnetische Induktor mit seinen vorteilhaften Eigenschaften innerhalb eines Anregungssystems voll ausgenutzt wird, indem er als induktiver Blindwiderstand, der nicht mehr in Reihe zur Laser-Elektroden-Strecke geschaltet ist, die Hochspannungs-Entladung des Lasers bei entsprechender Auslegung nur in vernachlässigbarem Maße beeinträchtigen kann.

Im folgenden wird anhand der Zeichnung, in welcher in Fig. 1 und 2 der Stand der Technik und in Fig. 3 bis 9 mehrere Ausführungsbeispiele der Erfindung dargestellt sind, diese noch näher erläutert.

Darin zeigt in schematischer Darstellung:

Fig. 1 ein nach den Lehren der US-PS-4 275 317 aufgebautes, vereinfachtes pulsformendes Netzwerk mit in einem Längszweig angeordneten sättigbaren magnetischen Induktor LM 01 zur Schaltung der Anregungsenergie einer Laserkammer LK;

Fig. 2 den Gegenstand nach Fig. 1, erweitert durch einen weiteren Induktor LM 02 im Längszweig und eine Ladekapazität $C_{02}$ im Querzweig;

Fig. 3 das Anregungssystem nach der Erfindung in einer ersten Ausführung, wobei dem pulsformenden Netzwerk eine Blümlein-Schaltung BL (gestrichelt angedeutet) zugrunde liegt und der Induktor LM in einem Querzweig angeordnet ist;

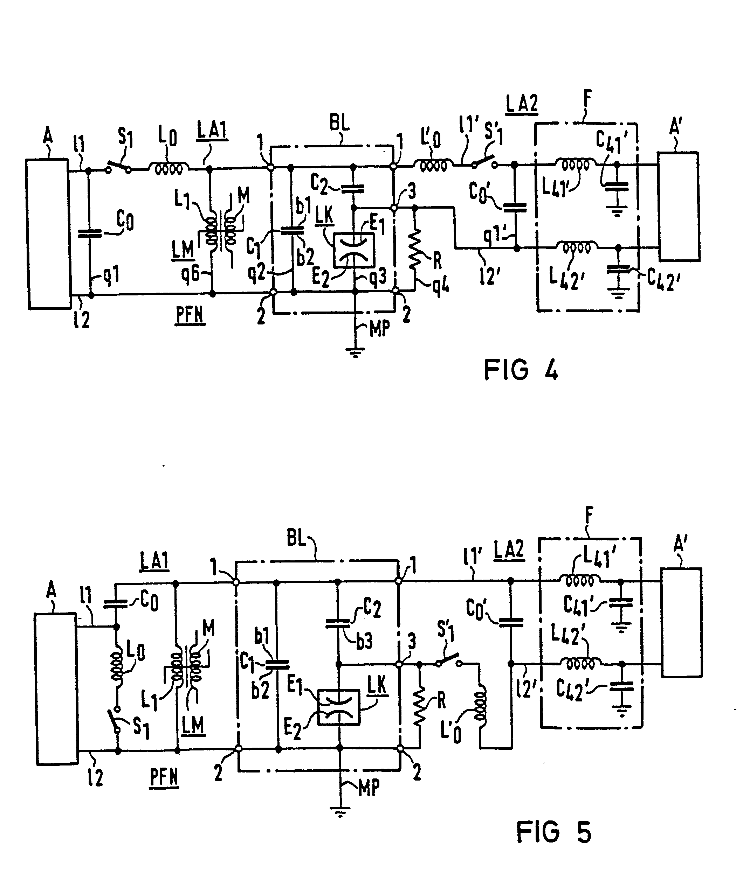

Fig. 4 ein zweites Ausführungsbeispiel des Anregungskreises nach der Erfindung, wobei die Schaltung nach Fig. 3 erweitert ist durch ein zweites Hochspannungs-Versorgungsgerät A';

Fig. 5 ein drittes Ausführungsbeispiel eines Anregungssystems, wobei jedoch die Schaltelemente $S_1$, $L_0$ und $C_0$ des Hochspannungs-Versorgungsgerätes A sowie die Schaltelemente $S_1'$, $L_0'$ und $C_0'$ des zweiten Hochspannungs-Versorgungsgerätes A' zur Erzielung einer besonderen Schaltcharakteristik umgruppiert wurden;

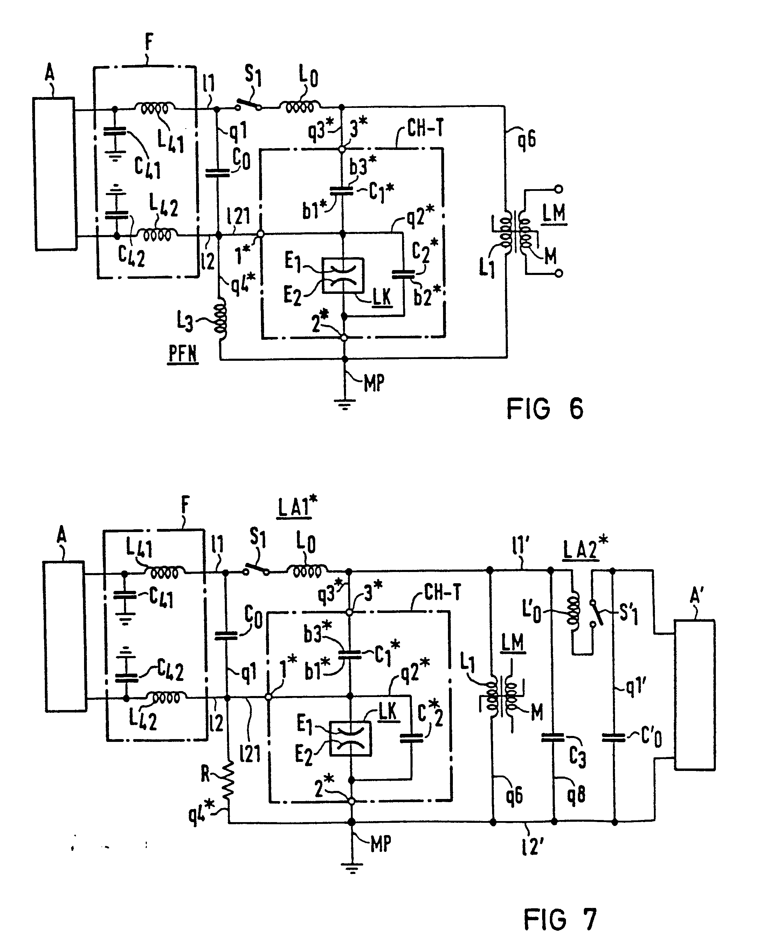

Fig. 6 ein viertes Ausführungsbeispiel des Anregungssystems mit einem pulsformenden Netzwerk, dem eine Charge-Transfer-Schaltung zugrunde liegt, wobei gleichfalls der magnetische Induktor als Schaltelement auch im Schaltfall einseitig auf Erdpotential gehalten wird;

Fig. 7 den Gegenstand nach Fig. 6, jedoch erweitert durch anschluß eines zusätzlichen Hochspannungs-Versorgungsgerätes A';

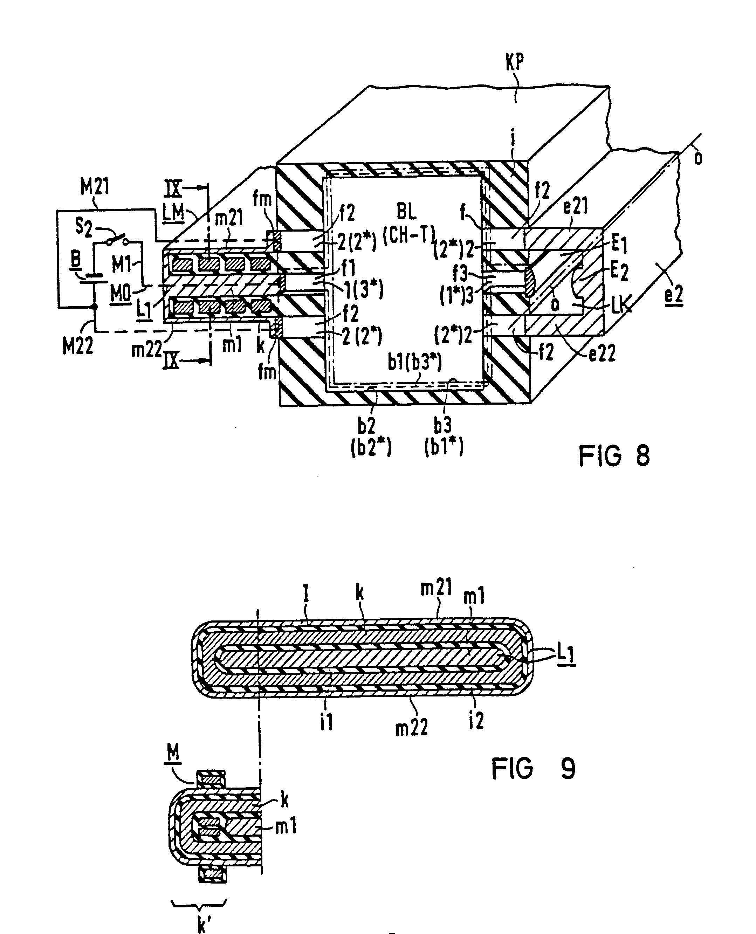

Fig. 8 in perspektivischer aufgeschnittener Detaildarstellung ein Bandleiter-Kondensatorpaket, baulich vereinigt mit einer Laserkammer an seiner rechten Längsseite und einem Induktor an seiner linken Längsseite, und

Fig. 9 den Schnitt längs der Schnittebene IX - IX aus Fig. 8, d. h. den inneren Stromzuführungsschenkel, der - unter Zwischenschaltung von Isolierschichten - umgeben ist von der hochpermeablen Wicklung der Kernschenkel und den Stromrückführungsschenkeln als äußere Lage, wobei der untere Teil der Fig. 9 eine abgewandelte Ausführung mit Kernschenkelverlängerung zeigt.

Zum besseren Verständnis der Erfindung sei zunächst die vereinfachte Ausführung eines bekannten Anregungssystems nach der US-PS-4 275 317 anhand von Fig. 1 erläutert. Darin bedeutet A ein Hochspannungs-Versorgungsgerät, das im allgemeinen Gleichspannung liefert, an welches die beiden Längszweige 11 (Plusschiene) und 12 (Masseschiene) angeschlossen sind, wobei die Plusschiene über einen Hochspannungsschalter $S_{01}$, eine nicht sättigbare Drossel $L_{00}$ und - als weitere Drossel - über die Arbeitswicklung L 01 eines sättigbaren magnetischen Induktors LM 01(mit sekundärseitiger Steuerwicklung M 01) an die eine Elektrode $E_1$ der Laserkammer LK und die Masseschiene 12 an die Gegenelektrode $E_2$ der Laserkammer LK angeschlossen ist. Arbeits- und Steuerwicklung können jeweils auch nur aus lediglich einer Windung bestehen, die im besonderen aus der Plus- und der Masse-Schiene gebildet sein kann. Der Masseanschluß ist mit MP bezeichnet. Der Zwischenspeicherkondensator $C_{00}$ liegt in einem ersten Querzweig $q_1$ noch vor dem Schalter $S_{01}$, der Ladekondensator $C_{01}$ in einem zweiten Querzweig q2 zwischen der Drossel $L_{00}$ und dem Induktor LM 01. Parallel zu der im dritten Querzweig q3 liegenden Laserkammer LK ist noch die weitere Drossel $L_{03}$ in einem weiteren Querzweig q4 geschaltet. Durch Schließen des Schalters $S_{01}$ wird von dem Hochspannunungs-Versorgungsgerät A mit dem Zwischenspeicherkondensator $C_{00}$ der Ladekondensator $C_{01}$ über die Drossel $L_{00}$ in Resonanzladung auf einen Spannungsscheitelwert aufgeladen, bei dem gerade der Induktor LM 01 in den gesättigten Zustand gelangt. Der dazu erforderliche Magnetisierungsstrom fließt durch die nicht sättigbare Drossel $L_{03}$ an den Laserelektroden $E_1$, $E_2$ vorbei. Der Spannungsabfall an der Drossel $L_{03}$ muß während der Magnetisierungsphase kleiner als die Durchbruchspannung der Laserkammer LK gehalten werden. Erst nach Sättigung des Induktors LM 01 liegt die weit über der Durchbruchspannung liegende Ladespannung des Kondensators $C_{01}$ an den Laserelektroden $E_1$, $E_2$ an, und der Kondensator $C_{01}$ entlädt sich über die nicht zu vernachlässigende Restinduktivität des in Reihe liegenden gesättigten Induktors LM 01 in das sich zwischen den Laserelektroden $E_1$ und $E_2$ ausbildende Plasma.

Die Pulsdauer des Entladestromes wird durch die Induktivität des Induktors LM 01 im gesättigten Zustand und die Kapazität $C_{01}$ bestimmt. Die Pulsdauer zur Aufladung von $C_{01}$ dagegen wird durch die Induktivität $L_{00}$ und die Reihenschaltung der Kondensatoren $C_{00}$ und $C_{01}$ definiert.

Die Aufladezeit kann erfahrungsgemäß durch die Induktivität der Drossel $L_{00}$ bis zu einem Faktor 10 gegenüber der Entladezeit verlängert werden. Das Verhältnis von Aufladezeit zu Entladezeit nennt man Kompressionsfaktor. Er ist vorgegeben durch die Materialeigenschaften des magnetischen Werkstoffes sowie durch den geometrischen Aufbau des als Schaltelement dienenden Induktors LM 01.

Um den Induktionshub des Induktors LM 01 stets in voller Höhe ausnutzen zu können, ist die eingangs als Steuerwicklung bezeichnete Sekundärwicklung Mo1 vorgesehen, über die das Magnetmaterial in der Pulspause mit einem kontinuierlichen oder gepulsten Gleichstrom in die Sättigung entgegengesetzter Polarität zurückversetzt werden kann. Während der Aufladungsphase des Kondensators $C_{01}$ fließt durch den Schalter $S_{01}$ aufgrund der Ladungserhaltung ein um den Kompressionsfaktor niedrigerer Strom als der Strom im Laseranregungskreis bzw. im Querzweig q3. Zur Vereinfachung ist im folgenden stets von einem Induktor LM 01 oder LM 02 die Rede und nicht von den Arbeits- und Steuerwicklungen.

Eine weitere Erniedrigung der vom Schalter $S_{01}$ zu schaltenden Stromstärke gelingt durch die Schaltung nach Fig. 2. Gleiche Teile tragen gleiche Bezugszeichen. Dort ist im Längszweig l1 zwischen dem Induktor LM 01 und dem Anschluß des Querzweiges q3 ein weiterer sättigbarer magnetischer Induktor LM 02 eingefügt, und an einem Anschlußpunkt des Längszweiges l1 zwischen den beiden Induktoren LM 01 und LM 02 ist ein weiterer Zwischenkondensator $C_{02}$ angeschlossen, der als weiterer Querzweig q5 mit seinem anderen Pol an der Erdschiene 12 liegt. Hierbei wird mit dem Induktor LM 01 der Zwischenkondensator $C_{02}$ auf einen Spannungsscheitelwert aufgeladen, bei dem dann der weitere Induktor LM 02 in die Sättigung gelangt und jetzt den Kondensator $C_{02}$ in die Laserkammer LK entlädt. Durch die Zwischenschaltung der Schaltelemente $C_{02}$ und LM 02 wird eine weitere Pulskompression erzielt.

Wie eingangs bereits erwähnt haben die Pulskompressionsschaltungen nach Fig. 1 und 2 einen wesentlichen Nachteil:

Der gesamte Laserstrom und damit die gesamte in der Laserkammer LK umgesetzte Energie muß durch die mit der Laserkammer LK in Reihe geschalteten Drosseln (Induktoren LM 01 bzw. LM 02) fließen, wobei die Induktoren bei hohen zu schaltenden elektrischen Energien eine beträchtliche Restinduktivität im gesättigten Zustand behalten. Diese Restinduktivität erhöht · erheblich die Impedanz des Laserentladungskreises im Vergleich zu einer Schaltung, die nur aus der Laserkammer LK und dem Kondensator $C_{01}$ bestünde. Für eine effektive Anregung des Lasergases erweist sich eine hohe Impedanz als schädlich.

Durch die Erfindung sind die vorerwähnten Nachteile des Einsatzes von sättigbaren magnetischen Induktoren zum großen Teil vermieden, was im folgenden zunächst anhand des ersten Ausführungsbeispiels der Fig. 3 erläutert wird. Dabei geht die Erfindung aus von einem Anregungssystem zur Erzeugung einer schnellen, gepulsten Hochspannungsentladung an einem Verbraucher, insbesondere zur Anregung eines Hochleistungslasers, durch möglichst homogene, lichtbogenfreie Kondensatorentladung, wie es in der DE-OS-2 932 781 und in weiteren Ausgestaltungen z. B. in den älteren EP-Patentanmeldungen gemäß EP-A-0 092 088, EP-A-0 092 087 und EP-A-0 074 586 beschrieben ist. Geeignete Vorionisierungseinrichtungen für derartige Anregungssysteme sind in der DE-OS-3 035 730 und in der DE-OS-3 035 702 beschrieben; sie werden, da zum Verständnis der vorliegenden Erfindung nicht erforderlich, hier nicht nochmals erläutert.

Die in Fig. 3 dargestellte Laserkammer LK ist bevorzugt ein TE-Laser mit mindestens zwei im Gasraum der Laserkammer LK mit Abstand einander gegenüberliegenden Laserelektroden $E_1$, $E_2$, welche, wie gestrichelt perspektivisch angedeutet, jeweils parallel zur optischen Achse oo der Laserkammer LK sich erstrecken und bevorzugt einen in dieser Richtung ausgedehnten Vollquerschnitt E aufweisen. Unter Laserkammer LK versteht man die Laserelektroden $E_1$, $E_2$ mit Gastank GT, in dem sie gasdicht umschlossen und befestigt sind. Dabei können Wandteile des Gastanks als metallische Stromrückführung ausgebildet sein und die elektrische Durchführung für die Stromzuführung aufnehmen. Für "Laserkammer" ist auch der Ausdruck "Laserkopf" gebräuchlich. Ebenso wie in Fig. 1 und Fig. 2 sind vorhanden: Das Hochspannungs-Versorgungsgerät A, die daran angeschlossenen Längszweige l1 (Plusschiene) und 12 (Erdschiene), der erste bis vierte Querzweig q1 bis q4, wobei jedoch die darin angeordneten Schaltelemente mit $C_0$ (Zwischenspeicherkondensator), $C_1$ (erster Bandleiterkondensator), $C_2$ (zweiter Bandleiterkondensator in Reihe zur Laserkammer LK) und $L_3$ (Drossel mit niedriger Impedanz für Frequenz des Ladestromes des Kondensators $C_2$ und hoher Impedanz bezüglich der Frequenz des Laser-Entladestromes) bezeichnet sind. Unter Querzweig q3 der Laserkammer LK wird hier die Reihenschaltung aus dem Bandleiterkondensator $C_2$ und der Laserkammer LK selbst verstanden. Das pulsformende Netzwerk PFN umfaßt die dargestellte Schaltung ohne das Hochspannungs-Versorgungsgerät A, an dessen Klemmen A1 und A2 es angeschlossen ist, und ohne die Laserkammer LK. Es umfaßt die schon erwähnten in Reihe und parallel zur Laserkammer LK bzw. der Laser-Elektroden-Strecke $E_1$ - $E_2$ liegenden ersten und zweiten Bandleiter-Kondensatoren $C_1$, $C_2$ sowie nicht näher dargestellten Längs- und Querinduktivitäten, die sich insbesondere aus der Eigeninduktivität der Laserkammer LK, ihrer Zuleitungen und der der Bandleiterkondensatoren $C_1$, $C_2$ ergeben. Durch die gestrichelte Rechteckumrahmung BL wird zum Ausdruck gebracht, daß die Laserkammer LK und ihre Bandleiterkondensatoren $C_1$, $C_2$ in einer

Blümlein-Schaltung angeordnet sind, die also einen Teil des pulsformenden Netzwerkes PFN bildet. Das nun in einem weiteren, den Bandleiter-Kondensatoren $C_1$, $C_2$ vorgeschalteten Querzweig q6 liegende schnelle Hochspannungs-Schaltelement, durch dessen Aktivierung (wie in der DE-OS-2 932 781 näher erläutert) über das pulsformende Netzwerk PFN die Hochspannungsimpulse an den Laser-Elektroden $E_1$, $E_2$ erzeugbar sind, ist erfindungsgemäß als sättigbarer magnetischer Induktor LM ausgebildet, dessen Magnetisierungsstrom den Induktor LM in Sättigung gehen läßt, wenn die Ladespannung an den Bandleiter-Kondensatoren $C_1$, $C_2$ in den Bereich ihres Scheitelwertes gelangt ist. Hier wie im folgenden wird unter Induktor LM eine sättigbare Drossel verstanden, die zumindest eine Arbeits- bzw. Primärwicklung $L_1$ und gegebenenfalls eine Steuerwicklung M aufweist. Wie bereits erwähnt, können diese Wicklungen auch aus lediglich einer Windung bestehen.

Die Anordnung der Bandleiterkondensatoren $C_1$ und $C_2$ sowie ihre Zuordnung zur Laserkammer LK ist insbesondere so getroffen, wie in der DE-OS-2 932 781 näher beschrieben, um eine möglichst kompakte Anordnung zu erhalten. Eine Vorstellung von dieser kompakten Anordnung gibt Fig. 8, auf die weiter unten noch eingangen wird. Die Wirkungsweise der Schaltung nach Fig. 3 ist wie folgt:

Vom Hochspannungs-Versorgungsgerät A mit dem Zwischenspeicherkondensator $C_0$ wird durch Schließen des Schalters $S_1$ die Bandleiterkondensator-Anordnung $C_1$, $C_2$ innerhalb ihrer Blümlein-Schaltung BL aufgeladen. Die Aufladezeit wird durch Dimensionierung der nicht sättigbaren Drossel $L_0$ so bemessen, daß bei Erreichen des Spannungsscheitelwertes der Induktor LM gerade in die Sättigung gelangt. Der Aufladestrom des zweiten Bandleiterkondensators $C_2$ fließt über die Drossel $L_3$, die im Querzweig q4 parallel zur Laserkammer LK geschaltet ist. Während der Aufladephase tritt ein Spannungsimpuls (Spannungsabfall an der nicht sättigbaren Drossel $L_3$) zwischen den Elektroden $E_1$ und $E_2$ auf, wobei darauf zu achten ist, daß dieser Spannungsimpuls nicht eine solche Größe hat, daß durch ihn die Gasentladung ungewollt zünden kann. Der Magnetisierungsstrom des Induktors LM fließt als ein Teilstrom parallel an dem durch die Blümlein-Schaltung BL gebildeten Anregungssystem vorbei. Bei Erreichen der Sättigung lädt sich der Kondensator $C_1$ über den Induktor LM in einer schwingenden Entladung auf einen Spannungsscheitelwert mit entgegengesetzter Polarität um, so daß die zunächst parallel aufgeladenen Kondensatoren $C_1$ und $C_2$ in Reihe liegen, und unter Vernachlässigung von Verlusten tritt maximal die doppelte Spannung über den Laserelektroden $E_1$ und $E_2$ auf, und die Laserkammer LK wird gezündet. Die nun in Reihe geschalteten Kondensatoren $C_1$ und $C_2$ entladen

sich in die Laserkammer, wobei der Laseranregungsstrom nicht über das Schaltelement LM fließen muß, dessen Restinduktivität wesentlich größer ist als die Gesamtinduktivität des Laseranregungskreises, bestehend aus $C_1$, $C_2$ und der Laserkammer LK. Diese geringe Induktivität des Laseranregungskreises wirkt sich außerordentlich günstig auf die Effektivität des Lasers aus. Im Gegensatz zu den in Fig. 1 und Fig. 2 dargestellten Anordnungen muß hier beim Umladevorgang lediglich der in $C_1$ gespeicherte Energiebetrag durch den gesättigten Induktor LM transportiert werden, während der Laserkammer LK die Summe der auf $C_1$ und $C_2$ gespeicherten Energiebeträge zugeführt wird. Diese Eigenschaft der Schaltung stellt sich als besonderer Vorteil dar, da Magnetschalter, wie bereits erläutert, mit nicht zu vernachlässigenden Verlusten behaftet sind, die den Wirkungsgrad des Lasers verschlechtern. Eine weitere Reduzierung der Schaltverluste im Magnetschalter ergibt sich bei Verwendung einer unsymmetrischen Blümlein-Schaltung, wie sie in der bereits erwähnten älteren Anmeldung gemäß EP-A-092 088 beschrieben ist.

Eine homogene Entladung zwischen den Laserelektroden gibt eine maximal zulässige Spannungsanstiegszeit an der Laserkammer LK vor. Diese wird bei dem Anregungssystem der Blümlein-Schaltung BL durch die Restinduktivität der Arbeitswicklung bzw. sättigbaren Drossel $L_1$ und die Kapazität $C_1$ definiert. Die Aufladezeit für die Parallelschaltung aus $C_1$ und $C_2$ wird durch die Induktivität der Vorschaltdrossel $L_0$ eingestellt. Es gilt für die Aufladezeit $t_{L1}$:

$$t_{L1} = \pi \sqrt{L_0 \frac{C_0 \cdot (C_1 + C_2)}{C_0 + (C_1 + C_2)}}$$

Auch bei der maximal möglichen Pulskompression ist die notwendige Aufladezeit relativ kurz und somit der auftretende Spitzenstrom für die Aufladung relativ hoch.

Um a) den Aufladestrom weiter zu erniedrigen und b) einen durch den Aufladestrom an $L_3$ auftretenden unerwünschten Spannungsabfall zu verhindern, kann man ein Anregungssystem gemäß Fig. 4 (zweites Ausführungsbeispiel) vorsehen. Im Vergleich zu Fig. 3 ist in Fig. 4 die Anordnung so getroffen, daß zusätzlich zum ersten Hochspannungs-Versorgungsgerät A ein zweites, gleichartiges Hochspannungs-Versorgungsgerät A' (rechter Teil der Fig. 4) über einen Zwischenspeicher-Kondensator $C_0'$ in einem Querzweig q1' und der Reihenschaltung aus dem Schalter $S_1'$ und der Vorschalt-Drossel $L_0'$ in einem zusätzlichen Längszweig l1'(die Erdschiene ist sinngemäß mit 12' bezeichnet) an die Blümlein-Schaltung BL des pulsformenden Netzwerkes PFN angeschlossen ist. Und zwar ist insbesondere das zweite Hochspannungs-Versorgungsgerät A' über seine beiden Längszweige l1', 12' an die beiden Pole des mit der Laserkammer LK in Reihe liegenden und den Querzweig q3 bildenden zweiten Bandleiter-

Kondensators $C_2$ angeschlossen. Die Kapazitäten $C_1$ und $C_2$ werden also von zwei getrennten Hochspannungs-Versorgungsgeräten A und A' sowie die separaten Zwischenspeicherkondensatoren $C_0$ und $C_0'$ über die beiden Schalter $S_1$ und $S_1'$ aufgeladen. Das Ladegerät A' wird über die Tiefpaßfilter-Anordnung F mit der LC-Anordnung bzw. der Siebkette aus $C_{41}'$ und $L_{41}'$ im Längszweig $l1'$ sowie der LC-Anordnung bzw. der Siebkette aus $C_{42}'$ und $L_{42}'$ im unteren Längszweig $l_2'$ von dem an der Laserkammer LK auftretenden Hochspannungsimpuls wechselspannungsmäßig abgekoppelt. Die beiden Schalter $S_1$ und $S_1'$ werden gleichzeitig gezündet und die Aufladezeiten über $L_0$ und $L_0'$ einander angeglichen. Der Widerstand R kann bei diesem pulsformenden Netzwerk hochohmig sein; er hält die Laserelektroden in den Entladungspausen auf gleichem Potential. Zum gleichzeitigen Zünden sind die Schalter $S_1$ und $S_1'$ bevorzugt elektronische Schalter, z. B. Thyratrons, die mit Steuermitteln zu ihrem gleichzeitigen Zünden versehen sind. Bei Vorhandensein des hochohmigen Widerstandes R parallel zur Laserkammer LK (wie dargestellt) gilt dann im besonderen für die Aufladezeiten $t_{L1}$ der ersten Ladeschleife LA 1 und $t_{L2}$ der zweiten Ladeschleife LA 2 des pulsformenden Netzwerkes PFN:

$$t_{L2} = \pi\sqrt{L_0'\,\frac{C_0' \cdot C_2}{C_0' + C_2}} = t_{L1} = \pi\sqrt{L_0\frac{C_0 \cdot C_1}{C_0 + C_1}}$$

Hierbei ist es also so, daß die Kapazität $C_2$ im wesentlichen durch die Ladeschleife LA 2 des zweiten Versorgungsgerätes A' aufgeladen wird; es ist nicht mehr erforderlich, den Ladestrom dieser Kapazität über eine niederohmige Drosse $L_3$ so wie in Fig. 3 zu führen. Durch die Doppel-Einspeisung läßt sich die Aufladezeit $t_L$ verkürzen, ohne einen Vorimpuls über den Elektroden $E_1$ und $E_2$ befürchten zu müssen, wobei durch die vorerwähnte Abstimmung der Aufladezeiten beider Ladeschleifen gewährleistet ist, daß der Induktor LM wirklich im Spannungsscheitelwert der Blümlein-Schaltung BL schaltet.

Beim dritten Ausführungsbeispiel nach Fig. 5, dem gleichfalls eine Blümlein-Schaltung BL zugrundeliegt, ist die Schaltung nach Fig. 4 durch Vertauschen des Zwischenspeicherkondensators $C_0$ mit der Reihenschaltung aus dem Schalter $S_1$ und der Vorschaltdrossel $L_0$ derart abgewandelt, daß der Schalter $S_1$ nun mit einem Pol auf Erdpotential und die Reihenschaltung aus $C_0$, $L_0$ und $S_1$ parallel zum Induktor LM und dementsprechend parallel zum ersten Bandleiter-Kondensator $C_1$ liegen. Weiterhin ist innerhalb der zweiten Ladeschleife LA 2 die Reihenschaltung aus dem Schalter $S_1'$ und der Vorschaltdrossel $L_0'$ aus dem auf Pluspotential liegenden "oberen" Längszweig $l1'$ in den über die laserparallel-geschaltete Impedanz R an Masse MP angeschlossenen "unteren" Längszweig $l2'$ derart transponiert, daß sich entsprechend der Schaltelement-Folge $S_1$ - $L_0$ - $C_0$ - $C_1$ - $S_1$ der ersten Ladeschleife LA 1 die Schaltelement-Folge $S_1'$ - $L_0'$ - $C_0'$ - $C_2$ - $S_1'$ der zweiten Ladeschleife LA 2 ergibt. Diese Schaltung ergibt die Möglichkeit, als Schalter $S_1$ ein einseitig auf Erdpotential liegendes Thyratron zu verwenden, das sich technisch einfacher ansteuern läßt.

Dieser Vorteil ließe sich selbstverständlich durch entsprechende Vertauschung der Schaltelemente $S_1$, $L_0$ einerseits und $C_0$ andererseits bei der Schaltung nach Fig. 3 verwirklichen.

Dem Anregungssystem nach Fig. 6 (viertes Ausführungsbeispiel) ist eine Charge-Transfer-Schaltung CH-T zugrundegelegt. In erster Näherung kann man sich diese Schaltung dadurch entstanden denken, daß man in der Blümlein-Schaltung nach Fig. 3 die Laserkammer LK und das Schaltelement in Form des Induktors LM miteinander vertauscht. Ein sättigbarer, magnetischer Induktor kann auch in Charge-Transfer-Schaltung zufriedenstellend als Schaltelement eingesetzt werden, wenn er - wie in Fig. 6 und 7 dargestellt - in einem Querzweig q6 angeordnet ist. Die eigentliche Charge-Transfer-Schaltung CH-T ist durch gestrichelte Rechteck-Umrahmung hervorgehoben; das gesamte pulsformende Netzwerk ist wieder mit PFN bezeichnet. Der in dem Querzweig q3* in Reihe mit der Laserkammer LK liegende erste Bandleiterkondensator ist mit $C_1^*$ bezeichnet, der parallel zur Laserkammer LK im Querzweig q2* liegende zweite Bandleiterkondensator mit $C_2^*$. Die Zusammenfassung der Laserkammer LK mit dem in Reihe zu ihr geschalteten Bandleiter-Kondensator $C_2$ (Fig. 3 bis 5) bzw. $C_1^*$ (Fig. 6 und 7) zu einem Querzweig q3 bzw. q3* ist deshalb sinnvoll, weil in der konstruktiven Ausführung des Anregungssystems (vgl. Fig. 8) die Bandleiter-Kondensatoren mit der Laserkammer eine kompakte bauliche Einheit bilden, wobei die zur Schaltverbindung dienenden Anschlüsse zwecks möglichst geringer Streuinduktivität auf eine minimale Länge reduziert sind. Das Hochspannungs-Versorgungsgerät A ist in diesem Falle über Tiefpaßfilter F, bestehend aus den beiden Siebketten $C_{41}$ - $L_{41}$ im oberen Längszweig $l1$ und $C_{42}$ - $L_{42}$ im unteren Längszweig $l2$, von dem an der Laserkammer LK und von dem am in Reihe dazu liegenden Bandleiterkondensator $C_1^*$ auftretenden Hochspannungs-Impuls wechselspannungsmäßig entkoppelt. Analog zur Schaltung nach Fig. 3 oder Fig. 4 erfolgt die Ankopplung des Stromversorgungsgerätes A wieder über einen Zwischenspeicherkondensator $C_0$ im Querzweig q1 und den Hochspannungsschalter $S_1$ mit in Reihe dazu liegender Vorschaltdrossel $L_0$ im oberen Längszweig $l1$. Die Siebketten-Schaltung F ist bevorzugt dann erforderlich, wie auch im Falle der Fig. 4 und 5, wenn das Hochspannungs-Versorgungsgerät A (bzw. A') über den oberen und unteren Längszweig $l1$, $l2$ an einen in Reihe zum Laserkopf LA liegenden Bandleiter-

Kondensator $C_1^*$ (bzw. im Falle der Fig. 4 und 5 an den Bandleiterkondensator $C_2$) angekoppelt wird.

Von dem Hochspannungs-Versorgungsgerät A wird der Zwischenspeicherkondensator $C_0$ aufgeladen. Bei Schließen des Schalters $S_1$ wird der Kondensator $C_1^*$ über die Vorschaltdrossel $L_0$ in Resonanzladung aufgeladen. Ein geringer Teilstrom fließt durch den Induktor LM und die mit ihm in Reihe liegende, jedoch im Zweig q4* parallel zur Laserkammer geschaltete Drossel $L_3$ über den Längs-Teilzweig l21 zurück zum Kondensator $C_0$. Die Aufladezeit

$$t_L = \pi \sqrt{L_0 \tfrac{C_1^* \cdot C_0}{C_1^* + C_0}}$$

ist wieder so bemessen, daß der Induktor LM gerade bei Erreichen des Spannungsscheitelwertes an Bandleiterkondensator $C_1^*$ gesättigt wird. Der Spannungsabfall an der Drossel $L_3$ ist relativ klein gegenüber dem Spannungsscheitelwert, so daß während der Auflade- und Magnetisierungsphase nur ein geringer Spannungsimpuls an der Laserkammer LK auftreten kann. Bei Erreichen der Sättigung des Induktors LM geht dieser in den Zustand minimaler Induktivität über, so daß der Kondensator $C_1^*$ den Kondensator $C_2^*$ auflädt (der sogenannte Ladungstransfer der der Schaltung seinen Namen gegeben hat). Die Aufladung des Kondensators $C_2^*$ führt zu einem Spannungsimpuls über der Laserkammer LK, der die Ausbildung eines Plasmas zwischen den Elektroden $E_1$ und $E_2$ bewirkt. Das Tiefpaßfilter F schützt, wie bereits erwähnt, das Versorgungsgerät A vor den auftretenden hochfrequenten Hochspannungsimpulsen.

Durch eine zweite Gleichspannungs-Einspeisung mit dem Hochspannungs-Versorgungsgerät A' nach Fig. 7 erhält man auch bei einem Anregungssystem mit Charge-Transfer-Schaltung den Vorteil, daß man den Spannungsabfall an der Drossel $L_3$ über der Laserkammer LK (nach Fig. 6) während der Aufladephase vermeidet. Im Vergleich zur Schaltung nach Fig. 6 wird in der Ausführung nach Fig. 7 zusätzlich zum ersten Hochspannungs-Versorgungsgerät A ein zweites, gleichartiger Hochspannunungs-Versorgungsgerät A' über einen Zwischenspeicherkondensator $C_0'$ in einem Querzweig q1' und über eine Reihenschaltung aus dem Schalter $S_1'$ und der Vorschalt-Drossel $L_0'$ in einem Längszweig l1' sowie bevorzugt einer zusätzlichen Kapazität $C_3$ in einem weiteren Querzweig q8 an den Querzweig q6 des Induktors LM angeschlossen. Hierbei ist wieder die parallel zur Laserkammer LK geschaltete Impedanz hochohmig, insbesondere ein im Vergleich zur Drossel $L_3$ nach Fig. 6 hochohmiger Widerstand R, der deshalb hochohmig sein kann, weil jetzt der Magnetisierungsstrom für den Induktor LM nicht mehr über die Impedanz R zu fließen braucht. Gleiche Teile in Fig. 7 im Vergleich zu Fig. 6 tragen wiederum die gleichen Bezugszeichen.

Innerhalb der zweiten Ladeschleife LA 2* wird der Kondensator $C_3$ von dem Kondensator $C_0'$ aufgeladen. Der Spannungsverlauf wird zu demjenigen an dem Kondensator $C_1^*$ identisch eingestellt. Ein geringer Teilstrom fließt als Magnetisierungsstrom durch den Induktor LM. Die Impedanz in Form des hochohmigen Widerstandes R hat hierbei wieder lediglich die Aufgabe, die Laserelektroden $E_1$ und $E_2$ bei langsamen Spannungsänderungen auf gleichem Potential zu halten.

Auch bei diesem Anregungssystem nach Fig. 7 ist es sehr wichtig, daß die Aufladezeit des relativ energiearmen Stromkreises, der lediglich den Magnetisierungsstrom aufbringen soll (Ladeschleife LA 2*), der Aufladezeit des hochenergetischen Aufladekreises (Ladeschleife LA 1*) angeglichen wird. Dann gilt, wenn man die Aufladezeit der zweiten Ladeschleife LA 2* mit $t_{L2}^*$ und die Aufladezeit der ersten Ladeschleife LA 1* mit $t_{L1}^*$ bezeichnet, zumindest in erster Näherung:

$$t_{L2^*} = t_{L1^*} = \pi \sqrt{L_0' \tfrac{C_0' \cdot C_3}{C_0' + C_3}} = \pi \sqrt{L_0 \tfrac{C_1^* \cdot C_0}{C_1^* + C_0}}.$$

Dabei wird die gespeicherte Energie in der Kapazität $C_0'$ etwas größer gewählt als die erforderliche Magnetisierungsenergie. Die vorstehend angegebene Formel gilt bevorzugt unter der Voraussetzung, daß die Schalter $S_1$ und $S_1'$ elektronische Schalter sind, welche mit Steuermitteln zu ihrem gleichzeitigen Zünden versehen sind, so daß dann der Induktor LM in Sättigung gelangt, wenn die Ladespannung an den Bandleiterkondensatoren $C_1^*$ und $C_3$ den Bereich ihres Scheitelwertes erreicht hat.

Von besonderer Bedeutung ist eine niedrige Restinduktivität des sättigbaren magnetischen Induktors LM, auch als Magnetschalter bezeichnet, die man durch die geometrische Anordnung und die Restpermeabilität der verwendeten Bänder oder Bleche für den Eisenkern vorgeben kann. Eine zweckmäßige Bemessung ist, wie erwähnt, die, daß die im Zwischenspeicherkondensator $C_0'$ der zusätzlichen Ladeschleife LA 2* gespeicherte Energie $C_0' \cdot U^2/2$ etwas größer gewählt ist als die zur Magnetisierung des Induktors LM erforderliche Energie $L \cdot I^2/2$, wobei I den Magnetisierungsstrom, L die Induktivität des Induktors LM im ungesättigten Zustand und U die Ladespannung des Kondensators $C_0'$ mit der Kapazität $C_0'$ bedeutet.

In Fig. 3 sind die beiden Anschlußpunkte des Induktors LM bezüglich der Blümlein-Schaltung BL mit 1 und 2 bezeichnet, die Anschlußpunkte der Drossel $L_3$ mit 3 und 2 (die beiden Anschlußpunkte 2, 2 des Induktors LM und der Drossel $L_3$ sind, da innerhalb der Masseschiene 12 angeordnet, potentialgleich). Man könnte diese durch kleine Kreise markierten Anschlußpunkte auch als fiktive Schnittstellen der gestrichelt eingerahmten Blümlein-Schaltung BL mit dem übrigen pulsformenden Netzwerk PFN auffassen. Eine sinngemäße Bezeichnung der Anschlußpunkte ist in Fig. 4 vorgenommen, wo, im Uhrzeigersinn gesehen, die Anschlußpunkte mit 1, 1, 3, 2, 2 bezeichnet sind (es ergibt sich ein zusätzlicher Anschlußpunkt 1 wegen der zweiten Ladeschleife LA 2). Eine entsprechende Bezeichnung der Anschlußpunkte geht aus Fig. 5 hervor. Die beiden in Fig. 6 und 7 dargestellten Anregungssysteme weisen im Gegensatz zu den in Fig. 3 bis Fig. 5 dargestellten nicht Blümlein-Schaltungen, sondern Charge-Transfer-Schaltungen innerhalb ihrer pulsformenden Netzwerke PFN auf, weshalb die Bezeichnung der Anschlußpunkte auch etwa abweichend, nämlich in Fig. 6 im Uhrzeigersinn gesehen mit 3*, 2* und 1* vorgenommen ist, wobei 3*, 2* die beiden Anschlußpunkte des Induktors LM bezüglich der Charge-Transfer-Schaltung CH-T sind und 1*, 2* die beiden Anschlußpunkte der Drossel $L_3$. Eine sinngemäße Bezeichnung der Anschlußpunkte 3*, 2* 1* ist in Fig. 7 getroffen.

Fig. 8 und 9 zeigen eine für alle Ausführungsbeispiele zugrunde zu legende vorteilhafte Ausführungsform einer kompakten Baueinheit, bestehend (siehe Fig. 8) aus der Laserkammer LK, dem damit vereinigten Bandleiter-Kondensator-Paket KP und der diesem Paket auf der anderen Längsseite zugeordneten und mit ihm vereinigten schnellen Hochspannungsschalter in Form des sättigbaren magnetischen Induktors LM. Wie es in der DE-OS-2 932 781, vgl. dort insbesondere Fig. 2 und 3, sowie Fig. 4 und 5, näher beschrieben ist, verlaufen in der kompakten Anordnung nach Fig. 8 die Bandleiter-Kondensatoren $C_1$, $C_2$ (gemäß vorstehenden Fig. 3 bis 5) und $C_1$*, $C_2$* (gemäß vorstehenden Fig. 6, 7) mit ihren Belägen und dazwischenliegenden dielektrischen Schichten im wesentlichen normal zur optischen Achse o - o der Laserkammer LK und sind im wesentlichen laserachsparallel zu dem Kondensatorpaket KP gestapelt sowie mit seitlich herausgeführten, generell mit f bezeichneten Anschlußfahnen (auch ein direkter Anschluß ist möglich) innerhalb des pulsformenden Netzwerkes PFN an die Laserkammer LK mit ihren beiden Elektroden $E_1$ und $E_2$ sowie an den Induktor LM an dessen Stromzuführungsschenkel m1 und an dessen Stromrückführungsschenkel m2, bestehend aus dem oberen und dem unteren Teilschenkel m21, m22, angeschlossen.

Die Anschlußfahnen f tragen im Spezialfalle die Ziffer der Anschlußpunkte, auf deren Potential sie sich befinden: So führt zur Laserelektrode $E_1$ die Anschlußfahne f3, und die beiden E-förmig von der Laser-Elektrode $E_2$ zurückgeführten metallischen Stromrückführungen e21, e22 der allgemein mit e2 bezeichneten Stromrückführung der Laserkammer LK sind mit den Anschlußfahnen f2 kontaktiert. Mit i ist allgemein die Isolierstoffmasse des Kondensatorpakets KP bezeichnet, die auch dazu dient, einen dichtenden Anschluß der Laserkammer LK herbeizuführen. Die in ihrer Bezifferung ebenfalls den Anschlußpunkten 1 bis 3 entsprechenden Kondensatorbeläge b1 bis b3 für die Blümlein-Schaltung BL sind außer in Fig. 8 auch in Fig. 3 bis 5 eingetragen; die in Fig. 8 in Klammern stehenden Bezeichnungen b1* bis b3* der Kondensatorbeläge und 1* bis 3* der Anschlußpunkte der Charge-Transfer-Schaltung CH-T auch in Fig. 6 und 7. Das Dielektrikum zwischen den einzelnen Belägen b2 (ausgezogene Kontur), b1 (gestrichelte Kontur) und b3 (strichpunktierte Kontur) der Kondensatorbeläge, welche sich über die Stapellänge des Paketes KP gesehen in regelmäßiger Folge wiederholen, kann gleichfalls aus einem Isolierstoff bestehen; es kann sich jedoch grundsätzlich auch, wie in der DE-OS-2 932 781 bereits erläutert, um einen Wasserkondensator oder um einen Kondensator mit einem anderen geeigneten flüssigen Dielektrikum handeln. Wie man sieht, ist die Laserkammer LK an der einen Längsseite des im Querschnitt rechteckförmigen Kondensatorpakets KP angeordnet. Bevorzugt ist in diesem Falle der sättigbare Induktor LM, wie es Fig. 8 zeigt, an der anderen Längsseite des Kondensatorpakets KP angeordnet. Dabei erfolgt die Schaltverbindung der Arbeitswicklung $L_1$ des Induktors zu den Bandleiter-Kondensator-Belägen b2 bzw. b1 über die Anschlußfahnen f2 bzw. f1 einerseits über den mittleren, laserachsparallel langgestreckten Stromzuführungsschenkel m1 (vgl. auch den Schnitt nach Fig. 9), andererseits über je einen außermittigen, laserachsparallel langgestreckten Stromrückführungsschenkel m21, m22, wobei die Stromrückführungsschenkel m21, m22 weitgehend bifilar zum Stromzuführungsschenkel m1 verlaufen und in den Hohlräumen zwischen den beiden Stromrückführungsschenkeln m21, m22 einerseits und dem Stromzuführungsschenkel m1 andererseits unter Zwischenschaltung von Isolierschichten il, i2 die insbesondere aus hochpermeablem, möglichst dünnem und einseitig isoliertem Bandmaterial gewickelten, in sich geschlossenen Kernschenkel k des Induktors LM, den Stromzuführungsschenkel m1 umfassend, angeordnet sind. Im Bereich der Anschlußstellen fm der Stromrückführungsschenkel m21, m22 sind diese abgewinkelt unter Bildung von Kontaktlaschen und mit entsprechenden Gegenkontaktflächen der Anschlußfahnen f2 des Kondensatorpaketes KP kontaktierend verbunden, z. B. durch Schrauben und/oder Löten. Auch die Kontaktierung des Stromzuführungsschenkels m1 erfolgt flächig an entsprechenden Gegenkontaktflächen fm der Kontaktfahnen f1.

Durch die generell mit MO bezeichneten und im Bereich des Induktors LM gestrichelten Linienzüge im linken Teil der Fig. 8 ist angedeutet, daß die Windungen der Steuerwicklung M die in sich geschlossenen Kernschenkel k des Induktors LM umfassen können, wobei der Stromkreis mit einer externen Gleichspannungsquelle B über die oberen und unteren Stromrückführungen M21, M22 und die mittlere Stromzuführung M1 mit Schalter $S_2$ geschlossen werden kann. Die einzelnen Windungen der Steuerwicklung M können dabei, wie angedeutet, durch den Stromzuführungsschenkel m1 hindurchgeführt und außerhalb der Kernschenkel k zur Steuerstromversorgung B wieder zurückgeführt sein; es ist zusätzlich dazu oder an Stelle dessen jedoch auch möglich, die in sich geschlossenen Kernschenkel k in Richtung der Schnittebene IX - IX zu verlängern und die Steuerwicklung M auf diesem verlängerten Schenkelast k' anzubringen, so wie in Fig. 9 unten angedeutet.

Die arabischen Ziffern 1 bis 3 der Kontaktfahnen f1 bis f3 und der Kondensatorbeläge b1 bis b3 korrespondieren mit den Anschlußpunkten der entsprechenden Blümlein-Schaltung BL nach Fig. 3 bis 5; durch das in Klammern gesetzte Bezugszeichen CH-T der Charge-Transfer-Schaltung nach Fig. 6 und 7 ist angedeutet, daß die Anordnung nach Fig. 8 auch für diese Schaltung verwendbar ist. Für diesen Fall sind die entsprechenden Anschlußpunkte der Charge-Transfer-Schaltung CH-T, nämlich 1* bis 3*, in Klammern neben die Ziffern der entsprechenden Anschlußpunkte der Blümlein-Schaltung BL gesetzt, desgleichen die Bezeichnung der entsprechenden Kondensatorbeläge b1* bis b3*. Die Bezeichnung der Anschlußfahnen f für die Charge-Transfer-Schaltung CH-T wurde in Fig. 8 nicht geändert.

Die Darstellung nach Fig. 8 und 9 ist als ein Ausführungsbeispiel für eine kompakte Anordnung eines Bandleiterkondensator-Paketes KP mit Laserkammer LK und Magnetschalter in Form des Induktors LM anzusehen. Es ist eine besonders günstige Ausführungsform. Grundsätzlich könnte indessen auch ein Kondensatorpaket KP vorgesehen sein, dessen Bandleiter-Kondensator-Beläge anstelle einer rechteckigen Grundfläche z. B. eine 5-, 6- oder n-eckige Grundfläche aufweisen könnten oder eine kreisförmige oder ovale Grundfläche. Es wäre auch möglich, auf dem Außenumfang eines solchen Paketes mehrere Laserkammern LK und mehrere Induktoren LM anzuordnen.

## Patentansprüche

1. Anregungssystem zur Erzeugung einer schnellen, gepulsten Hochspannungsentladung in einem Laser, insbesondere Hochleistungslaser, durch möglichst homogene, lichtbogenfreie Kondensatorentladung, bestehend aus:

a) einer Laserkammer (LK) mit mindestens zwei in ihrem Gasraum mit Abstand einander gegenüberliegenden Laser-Elektroden (E1, E2), welche jeweils parallel zur optischen Achse der Laserkammer sich erstrecken und bevorzugt einen in dieser Richtung ausgedehnten Vollquerschnitt aufweisen;

b) mindestens einem Hochspannungs-Versorgungsgerät (A);

c) einem pulsformenden Netzwerk (PFN),

c1) welches eingangsseitig an das Hochspannungs-Versorgungsgerät anschließbar und ausgangsseitig an die Laser-Elektroden angeschlossen ist;

c2) welches in Reihe und parallel zu der Laser-Elektroden-Strecke liegende erste und zweite Bandleiter-Kondensatoren sowie Längs- und Querinduktivitäten aufweist und

c3) welches in einem den Bandleiter-Kondensatoren vorgeschalteten Querzweig mindestens ein schnelles Hochspannungs-Schaltelement aufweist, durch dessen Aktivierung über das pulsformende Netzwerk Hochspannungsimpulse an den Laser-Elektroden erzeugbar sind,

dadurch gekennzeichnet, daß das schnelle Hochspannungs-Schaltelement als sättigbarer magnetischer Induktor (LM) ausgebildet ist, dessen Magnetisierungsstrom den Induktor in Sättigung gehen läßt, wenn die Ladespannung an den vom Hochspannungs-Versorgungsgerät aufladbaren Bandleiter-Kondensatoren ($C_1$, $C_2$; $C_1$*) in den Bereich ihres Scheitelwertes gelangt ist.

2. Anregungssystem nach Anspruch 1, dadurch gekennzeichnet, daß dem pulsformenden Netzwerk (PFN) eine Blümlein-Schaltung (BL) zugrunde gelegt ist.

3. Anregungssystem nach Anspruch 1 oder 2, dadurch gekennzeichnet, daß die parallel zum Laserkopf (LK) geschaltete Impedanz eine niederohmige Drossel ($L_3$) ist.

4. Anregungssystem nach Anspruch 2, mit einem Hochspannungs-Versorgungsgerät (A), welches über einen Zwischenspeicher-Kondensator ($C_0$) in einem Querzweig sowie die Reihenschaltung eines Schalters ($S_1$) und einer Vorschalt-Drossel ($L_0$) im Längszweig an den übrigen Teil des pulsformenden Netzwerkes (PFN) in Blümlein-Schaltung angeschlossen ist, dadurch gekennzeichnet, daß zusätzlich zum ersten Hochspannungs-Versorgungsgerät (A) ein zweites, gleichartiges Hochspannungs-Versorgungsgerät (A') über einen Zwischenspeicher-Kondensator ($C_0$') in einem Querzweig und der Reihenschaltung aus Schalter ($S_1$') und Vorschalt-Drossel ($L_0$') in einem Längszweig an die Blümlein-Schaltung des pulsformenden Netzwerkes (PFN) angeschlossen ist.

5. Anregungssystem nach Anspruch 4, dadurch gekennzeichnet, daß das zweite Hochspannungs-Versorgungsgerät (A') an die beiden Pole des mit dem Laserkopf (LK) in Reihe liegenden und einen Querzweig bildenden zweiten Bandleiter-Kondensators ($C_2$) angeschlossen ist.

6. Anregungssystem nach Anspruch 4 oder 5, dadurch gekennzeichnet, daß das zweite Hochspannungs-Versorgungsgerät (A') über Tiefpaßfilter (F) von dem am Laserkopf (LK) und dem am in Reihe dazu liegenden Bandleiter-Kondensator (C$_2$) auftretenden Hochspannungsimpuls wechselspannungsmäßig entkoppelt ist.

7. Anregungssystem nach einem der Ansprüche 4 bis 6, wobei die das Hochspannungs-Versorgungsgerät (A, A') an das pulsformende Netzwerk (PFN) anlegenden Schalter (S$_1$, S$_1$') elektronische Schalter, wie z. B. Thyratrons, sind, dadurch gekennzeichnet, daß die Schalter (S$_1$, S$_1$') mit Steuermitteln zu ihrem gleichzeitigen Zünden versehen und der Aufladezeiten (t$_{L1}$, t$_{L2}$) der ersten und der zweiten Ladeschleifen (LA 1, LA 2) über die Vorschalt-Drosseln (L$_0$, L$_0$') einander angeglichen sind, wobei gilt:

$$t_{L2} = \pi \sqrt{L_0'} \frac{C_0' \cdot C_2}{C_0' + C_2} = t_{L1} = \pi \sqrt{L_0 \frac{C_0 \cdot C_1}{C_0 + C_1}}.$$

8. Anregungssystem nach Anspruch 1, dadurch gekennzeichnet, daß dem pulsformenden Netzwerk (PFN) ein Charge-Transfer-Kreis (CH-T) zugrundegelegt ist.

9. Anregungssystem nach Anspruch 8, dadurch gekennzeichnet, daß das Hochspannungs-Versorgungsgerät (A) über Tiefpaßfilter (F) von dem am Laserkopf (LK) und dem am in Reihe dazu liegenden Bandleiter-Kondensator (C$_1$*) auftretenden Hochspannungs-Impuls wechselspannungsmäßig entkoppelt ist.

10. Anregungssystem nach Anspruch 8 oder 9, mit einem Hochspannungs-Versorgungsgerät (A), welches über einen Zwischenspeicher-Kondensator (C$_0$) in einem Querzweig sowie die Reihenschaltung eines Schalters (S$_1$) und einer Vorschalt-Drossel (L$_0$) im Längszweig an den übrigen Teil des pulsformenden Netzwerkes (PFN) in Charge-Transfer-Schaltung (CH-T) angeschlossen ist, dadurch gekennzeichnet, daß zusätzlich zum ersten Hochspannungs-Versorgungsgerät (A) ein zweites, gleichartiger Hochspannungs-Versorgungsgerät (A') über einen Zwischenspeicherkondensator (C$_0$') in einem Querzweig und über eine Reihenschaltung aus dem Schalter (S$_1$') und der Vorschalt-Drossel (L$_0$') in einem Längszweig sowie einer zusätzlichen Kapazität (C$_3$) in einem weiteren Querzweig an den Querzweig des Induktors (LM) angeschlossen ist.

11. Anregungssystem nach Anspruch 10, wobei die das Hochspannungs-Versorgungsgerät (A, A') an das pulsformende Netzwerk (PFN) anlegenden Schalter (S$_1$, S$_1$') elektronische Schalter sind, dadurch gekennzeichnet, daß die Schalter (S$_1$, S$_1$') mit Steuermitteln zu ihrem gleichzeitigen Zünden versehen sind und daß die Aufladezeit (t$_{L2}$*) der das zusätzliche Hochspannungs-Versorgungsgerät (A') enthaltenden Ladeschleife (LA 2*), welche im wesentlichen den Magnetisierungsstrom des Induktors (LM) aufbringt, und die Aufladezeit (t$_{L1}$*) der der Aufladung des Bandleiter-Kondensators (C$_1$*) dienenden und das erste Hochspannungs-Versorgungsgerät (A$_1$) enthaltenden Ladeschleife

(LA 1*) einander gleich sind, wofür in erster Näherung die Beziehung gilt:

$$t_{L2}* = t_{L1^*} = \pi \sqrt{L_0 \cdot \frac{C_0' \cdot C_3}{C_0' + C_3}} = \pi \sqrt{L_0 \frac{C_1' \cdot C_0}{C_1^* + C_0}}.$$

12. Anregungssystem nach einem der Ansprüche 10 oder 11 dadurch gekennzeichnet, daß die im Zwischenspeicherkondensator (C$_0$') der zusätzlichen Ladeschleife (LA 2*) gespeicherte Energie C$_0' \cdot \frac{U^2}{2}$ etwas größer gewählt ist als die zur Magnetisierung des Induktors (LM) erforderliche Energie L$_1 \cdot \frac{I^2}{2}$.

13. Anregungssystem nach einem der Ansprüche 1 bis 12, mit einer aus dem Laserkopf und den zugehörigen ersten und zweiten Bandleiter-Kondensatoren bestehenden Baueinheit, wobei die Bandleiter-Kondensatoren mit ihren Belägen und dazwischenliegenden dielektrischen Schichten im wesentlichen normal zur optischen Achse der Laserkammer verlaufen und im wesentlichen laserachsparallel zu einem Kondensatorpaket gestapelt und direkt oder mit seitlich herausgeführten Anschlußfahnen innerhalb des pulsformenden Netzwerkes angeschlossen sind, wobei ferner die Laserkammer an einer Längsseite des Kondensatorpaketes angeordnet ist, dadurch gekennzeichnet, daß der sättigbare Induktor (LM) an einer anderen Längsseite des Kondensatorpakets (KP) angeordnet ist und die Schaltverbindung der Arbeitswicklung (L$_1$) des Induktors zu den Bandleiter-Kondensator-Belägen (b1, b2 bzw. b3*, b2*) über einen mittleren, laserachsparallel langgestreckten Stromzuführungsschenkel (m1) und die Stromrückführung über je einen außermittigen, laserachsparallel langgestreckten Stromrückführungsschenkel (m21, m22) erfolgt, wobei die Stromrückführungsschenkel (m21, m22) weitgehend bifilar zum Stromzuführungsschenkel (m1) verlaufen und in den Hohlräumen zwischen den beiden Stromrückführungsschenkeln (m21, m22) einerseits und dem Stromzuführungsschenkel (m1) andererseits - unter Zwischenschaltung von Isolierschichten - die insbesondere aus hochpermeablem Bandmaterial gewickelten, in sich geschlossenen Kernschenkel (k) des Induktors, den Stromzuführungsschenkel (m1) umfassend, angeordnet sind.

14. Anregungssystem nach Anspruch 13, wobei die Bandleiterkondensator-Beläge Rechteckform und das Kondensatorpaket Quaderform aufweisen, dadurch gekennzeichnet, daß der sättigbare Induktor auf der dem Laserkopf (LK) gegenüberliegenden Längsseite des Kondensatorpakets angeordnet ist.

15. Anregungssystem nach Anspruch 13 oder 14, mit eine Steuerwicklung aufweisendem Induktor, dadurch gekennzeichnet, daß die Windungen der Steuerwicklung (M) die in sich geschlossenen Kernschenkel (k) des Induktors auf einem herausragenden Schleifenstück der Kernschenkel umfassen und/oder durch den Stromzuführungsschenkel (m1) hindurchgeführt und außerhalb der Kernschenkel (k) zur Steuerstromversorgung wieder zurückgeführt sind.

16. Anregungssystem nach Anspruch 2, <u>dadurch gekennzeichnet,</u> daß die Schaltung gemäß Anspruch 4 durch Vertauschen des Zwischenspeicherkondensators ($C_0$) mit der Reihenschaltung aus Schalter ($S_1$) und Vorschaltdrossel ($L_0$) derart abgewandelt ist, daß der Schalter ($S_1$) mit einem Pol auf Erdpotential und die Reihenschaltung aus ($C_0$, $L_0$ und $S_1$) parallel zum Induktor ($L_1$) und dementsprechend parallel zum ersten Bandleiter-Kondensator ($C_1$) liegen, und daß innerhalb der zweiten Ladeschleife (LA 2) die Reihenschaltung aus dem Schalter ($S_1'$) und der Vorschaltdrossel ($L_0'$) aus dem auf Pluspotential liegenden "oberen" Längszweig in den über die laserparallel-geschaltete Impedanz (R) an Masse angeschlossenen "unteren" Längszweig derart transponiert ist, daß sich entsprechend der Schaltelement-Folge ($S_1$ - $L_0$ - $C_0$ - $C_1$ - $S_1$) der ersten Ladeschleife (LA 1) die Schaltelement-Folge ($S_1'$ - $L_0'$ - $C_0'$ - $C_2$ - $S_1'$) der zweiten Ladeschleife (LA 2) ergibt.

17. Anregungssystem nach einem der Ansprüche 4, 5, 10 oder 16, <u>dadurch gekennzeichnet</u> daß die parallel zur Laserkammer (LK) geschaltete Impedanz eine hochohmige Impedanz, insbesondere ein im Vergleich zur Drossel ($L_3$) hochohmiger Widerstand (R) ist.

## Claims

1. Starting system for the production of a fast, pulsed high-voltage discharge in a laser, more particularly a high-power laser, by means of capacitor discharge which is as homogeneous as possible and free of electric arcs, consisting of:
   a) a laser compartment (LK) with at least two laser electrodes (E1, E2) in its gas compartment, lying opposite each other with a distance between them, which laser electrode, in each case extend parallel to the optical axis of the laser compartment, and preferably have a full cross section extended in this direction:
   b) at least one high-voltage supply apparatus (A);
   c) a pulse-shaping network (PFN),
      c1) which can be connected on the input side to the high-voltage supply apparatus and which is connected on the output side to the laser electrodes;
      c2) which has first or second strip-conductor capacitors lying in series and parallel to the laser electrode path, as well as longitudinal and quadrature inductances, and
      c3) which has at least one fast high-voltage switch element in a shunt arm, series-connected to the strip-conductor capacitors, the activation of which high-voltage switch element across the pulse-shaping network enables high-voltage impulses to be produced on the laser electrodes, characterized in that the fast high-voltage switch element is formed as a saturable magnetic inductance (LM), the magnetizing current of which lets the inductance become saturated, when the charging voltage on the strip-conductor capacitors ($C_1$, $C_2$; $C_1^*$), which can be charged by the high-voltage supply apparatus, has reached the region of its peak value.

2. Starting system according to claim 1, characterized in that a Blümlein circuit (BL) is taken as the basis for the pulse-shaping network (PFN).

3. Starting system according to claim 1 or 2, characterized in that the impedance, actuated parallel to the laser head (LK), is a low-resistance reactance coil ($L_3$).

4. Starting system according to claim 2 with a high-voltage supply apparatus (A) which is connected on to the remaining portion of the pulse-shaping network (PFN) in Blümlein circuit by means of a buffer storage capacitor ($C_0$) in a shunt arm, together with the series circuit of a switch ($S_1$) and of a series reactance coil ($L_0$) in the series arm, characterized in that in addition to the first high-voltage supply apparatus (A), a second high-voltage supply apparatus (A') of the same kind is connected to the Blümlein circuit of the pulse-shaping network (PFN), by means of a buffer storage capacitor ($C_0'$) in a shunt arm and the series circuit or switch ($S_1'$) and series reactance coil (L0') in a series arm.

5. Starting system according to claim 4, cbaracterized in that the second high-voltage supply apparatus (A') is connected to the two poles of the second strip-conductor capacitor ($C_2$) which lies in series with the laser head (LK) and forms a shunt arm.

6. Starting system according to claim 4 or 5, characterized in that the second high-voltage supply apparatus (A') is decoupled with respect to alternating voltage, by means of low-pass filters (F), from the high-voltage impulse which appears on the laser head (LK) and on the strip-conductor capacitor ($C_2$) which lies in series with the laser head.

7. Starting system according to one of claims 4 to 6, the switches ($S_1$, $S_1'$), which connect the high-voltage supply apparatus (A, A') to the pulse-shaping network (PFN), being electronic switches, such as for example thyratrons, characterized in that the switches ($S_1$, $S_1'$) are provided with control means for their simultaneous firing and the charge times ($t_{L1}$, $t_{L2}$) of the first and the second charge loops (LA 1, LA 2) are adjusted with respect to each other by means of the series reactance coils, ($L_0$, $L_0'$), whereby it applies that:

$$t_{L2} = \pi \sqrt{L_0 \cdot \frac{C_0 \cdot C_2}{C_0 + C_2}} = t_{L1} = \pi \sqrt{L_0 \frac{C_0 \cdot C_1}{C_0 + C_1}}.$$

8. Starting system according to claim 1, characterized in that a charge transfer circuit (CH-T) is taken as the basis for the pulse-shaping network (PFN).

9. Starting system according to claim 8, characterized in that the high-voltage supply apparatus (A) is decoupled with respect to alternating voltage, by means of low-pass filters (F), from the high-voltage impulse which appears on the laser head (LK) and on the strip-conductor capacitor (C₁*) which lies in series with the laser head.

10. Starting system according to claim 8 or 9 with a high-voltage supply apparatus (A) which is connected to the remaining portion of the pulse-shaping network (PFN), in charge transfer circuit (CH-T) by means of a buffer storage capacitor (C₀·) in a shunt arm, together with the series circuit of a switch (S₁) and of a series reactance coil (L₀) in the series arm, characterized in that in addition to the first high-voltage supply apparatus (A), a second high-voltage supply apparatus (A′) of the same kind is connected to the shunt arm of the inductance (LM), by means of a buffer storage capacitor (C₀′) in a shunt arm and by means of a series circuit of the switch (S₁′) and of the series reactance coil (L₀′) in a series arm as well as of an additional capacitance (C₃) in a further shunt arm.

11. Starting system according to claim 10, the switches (S₁, S₁′), which connect the high-voltage supply apparatus (A, A′) to the pulse-shaping network (PFN), being electronic switches, characterized in that the switches (S₁, S₁′) are provided with control means for their simultaneous firing, and that the charge time (t_{L2·}) of the charge loop (LA 2*), which contains the additional high-voltage supply apparatus (A′), and which essentially produces the magnetizing current of the inductance (LM), and the charge time (t_{L1·}) of the charge loop (LA 1*), which serves to charge the strip-conductor capacitor (C₁·) and which contains the first high-voltage supply apparatus (A₁), are the same as each other, to which in first approximation this equation applies:

$$t_{L2·} = t_{L1·} = \pi \sqrt{L_0 \cdot \tfrac{C_0 \cdot C_3}{C_0 + C_3}} = \pi \sqrt{L_0 \tfrac{C_1 \cdot C_0}{C_1 + C_0}}.$$

12. Starting system according to one of claims 10 or 11, characterized in that the energy $C_0′ \cdot \tfrac{U^2}{2}$ stored in the buffer storage capacitor (C₀′) of the additional charge loop (LA 2*) is selected to be somewhat greater than the energy $L_1 \cdot \tfrac{I^2}{2}$ necessary for magnetizing the inductance (LM).

13. Starting system according to one of claims 1 to 12 with a constructional unit, comprising the laser head and the associated first and second strip-conductor capacitors, the strip-conductor capacitors, with their plates and the dielectric layers lying between them, extending essentially perpendicularly to the optical axis of the laser compartment and which strip-conductor capacitors are stacked in a capacitor stack essentially parallel to the laser axis and are connected directly or using connecting lugs which are brought out to the side, within the pulse-shaping network, moreover the laser compartment being arranged on a long side of the capacitor stack, characterized in that the saturable inductance (LM) is arranged on a different long side of the capacitor stack (KP), and the circuit connection of the inductance's load winding (L₁) to the plates (b1, b2 or b3*, b2*) of the strip-conductor capacitors results by means of a central current-supply limb (m1), extended parallel to the laser axis, and the current return results by means of each off-centre current-return limb (m21, m22), extended parallel to the laser axis, the current-return limbs (m21, m22) branching to a large extent from the current-supply limb (m1), and the inductance's core limbs (k), which are more particularly wound out of highly permeable tape material, are compact in themselves and surround the current-supply limb (m1), being arranged in the hollow spaces between the two current-return limbs (m21, m22) on the one hand and the current-supply limb (m1) on the other hand, through the intermediary of insulating layers.

14. Starting system according to claim 13, the plates of the strip-conductor capacitors being rectangular in shape and the capacitor stack being square in shape, characterized in that the saturable inductance is arranged on the capacitor stack's long side which lies opposite the laser head (LK).

15. Starting system according to claim 13 or 14, with inductance having a control winding, characterized in that the turns of the control winding (M) encircle the inductance's core limbs (k), which are compact in themselves, on a projecting loop piece of the core limb and/or the turns are carried through the current-supply limb (m1) and outside of the core limb (k) are carried back again to the control current supply.

16. Starting system according to claim 2, characterized in that the circuit according to claim 4 is altered by exchanging the buffer storage capacitor (C₀) with the series circuit of switch (S₁) and series reactance coil (L₀), in such a way that the switch (S₁) lies with one pole at earth potential and the series circuit of (C₀ L₀ and S₁) lies in parallel with the inductance (L₁) and accordingly in parallel with the first strip-conductor capacitor (C₁), and that within the second charge loop (LA 2) the series circuit of the switch (S₁′) and of the series reactance coil (L₀′) is transposed out of the "upper" series arm, which lies at positive potential, into the "lower" series arm, which is connected to earth by means of the impedance (R), which is actuated in parallel with the laser, in such a way that corresponding to the circuit element sequence (S₁ - L₀ - C₀ - C₁ - S₁ of the first charge loop (LA 1) the circuit element sequence (S₁′ - L₀′ - C₀′ - C₂- S₁′) of the second charge loop (LA 2) results.

17. Starting system according to one of claims 4, 5, 10 or 16, characterized in that the impedance, actuated in parallel with the laser compartment (LK) is a high-resistance impedance, more particularly, in comparison with the reactance coil (L₃), a high-resistance resistor (R).

## Revendications

1. Système d'excitation pour produire une décharge impulsionnelle rapide de haute tension dans un laser, en particulier dans un laser à haute performance, par une décharge de condensateur, aussi homogène que possible et sans arc électrique, constitué par:

a) une chambre de laser (LK) avec au moins deux électrodes (E1, E2) se situant à distance l'une en face de l'autre dans l'enceinte à gaz, lesquelles électrodes s'étendant chacune parallèlement à l'axe optique de la chambre de laser et présentent, de préférence, dans cette direction une section transversale pleine et étendue,

b) au moins un appareil d'alimentation haute tension (A),

c) un réseau (PFN) formateur d'impulsions,

c1) qui est susceptible d'être relié côté entrée à l'appareil d'alimentation haute tension et côté sortie aux électrodes de laser,

c2) qui comporte des premiers et des seconds condensateurs à ruban montés en série et en parallèle à la voie des électrodes de laser, ainsi que des inductances longitudinales et transversales, et

c3) qui comporte dans une branche transversale située en amont des condensateurs à ruban, au moins un élément de commutation rapide haute tension grâce à l'activation duquel des impulsions haute tension sont susceptibles d'être produites au niveau des électrodes de laser, par l'intermédiaire du réseau formateur d'impulsions,

caractérisé par le fait que l'élément de commutation rapide haute tension est réalisé sous la forme d'un inducteur magnétique (LM) susceptible de saturation et dont le courant de magnétisation laisse passer l'induction en saturation si la tension de charge appliquée aux ~~ ~densateurs à ruban (C$_1$, C$_2$; C$_1$*) qui sont ~~tibles d'être chargés par l'appareil ~ntation haute tension vient à se situer ~ plage à sa valeur de crête.

~~ Système d'excitation selon la revendication 1. caractérisé par le fait que le réseau formateur d'impulsions (PFN) est à base d'un circuit Blümlein (BL).

3. Système d'excitation selon la revendication 1 ou 2, caractérisé par le fait que l'impédance qui est montée en parallèle sur la tête de laser (LK) est une self faiblement ohmique (L$_3$).

4. Système d'excitation selon la revendication 3, avec un appareil d'alimentation haute tension (A) et relié, par l'intermédiaire d'un condensateur accumulateur intermédiaire (C$_0$) prévu dans une branche transversale ainsi que par l'intermédiaire du circuit série d'un interrupteur (S$_1$) et d'une self amont (L$_0$) prévue dans la branche longitudinale, à la partie restante du réseau formateur d'impulsions (PFN) à circuit Blümlein, caractérisé par le fait qu'en plus du premier appareil d'alimentation haute tension (A), un second appareil d'alimentation haute tension (A') identique au premier, est relié au circuit Blümlein du réseau formateur d'impulsions (PFN), par l'intermédiaire d'un condensateur accumulateur intermédiaire (C$_0$') prévu dans une branche transversale et du circuit série constitué par un interrupteur (S$_1$') et une self amont (L$_0$') prévue dans une branche longitudinale.

5. Système d'excitation selon la revendication 4, caractérisé par le fait que le second appareil d'alimentation haute tension (A') est relié aux deux pôles du second condensateur à conducteurs à ruban (C$_2$) qui est monté en série avec la tête de laser (LK) et qui forme une branche transversale.

6. Système d'excitation selon la revendication 4 ou 5, caractérisé par le fait que le second appareil d'alimentation haute tension (A') est découplé, du point de vue de la tension alternative, par l'intermédiaire d'un filtre passe-bas (F), de l'impulsion haute tension qui apparaît à la tête de laser (LK) et au condensateur à conducteurs à ruban (C$_2$) qui est en série avec la tête de laser.

7. Système d'excitation selon l'une des revendications 4 à 6, du type dans lequel les interrupteurs (S$_1$, S$_1$') qui relient l'appareil d'alimentation haute tension (A, A') au réseau formateur d'impulsions (PFN), sont des interrupteurs électroniques, comme par exemple des Thyratrons, caractérisé par le fait que les interrupteurs (S$_1$, S$_1$') sont pourvus de moyens de commande pour leur déclenchement simultané et les durées de charge (t$_{L1}$, t$_{L2}$) des première et seconde boucles de charge (LA 1, LA 2) sont adaptées entre elles, par l'intermédiaire des selfs amont (L$_0$, L$_0$'), avec:

$$t_{L2} = \pi \sqrt{L_0 \cdot \frac{C_0 \cdot C_2}{C_0 + C_2}} = t_{L1} = \pi \sqrt{L_0 \frac{C_0 \cdot C_1}{C_0 + C_1}}.$$

8. Système d'excitation selon la revendication 1, caractérisé par le fait que le réseau formateur d'impulsions (PFN) est à base d'un circuit à transfert de charge (CH-T).

9. Système d'excitation selon la revendication 8, caractérisé par le fait que l'appareil d'alimentation haute tension (A) est découplé du point de vue de la tension alternative, par l'intermédiaire d'un filtre passe-bas (F), de l'impulsion haute tension qui apparaît à la tête de laser (LK) et au condensateur à conducteur à ruban (C$_1$*) qui est en série avec ladite tête de laser.

10. Système d'excitation selon la revendication 8 ou 9, avec un appareil d'alimentation haute tension (A) qui est relié, par l'intermédiaire d'un condensateur accumulateur intermédiaire (C$_0$) situé dans une branche transversale ainsi que par l'intermédiaire du circuit série constitué par un interrupteur (S$_1$) et une self amont (L$_0$) située dans la branche longitudinale, à la partie restante du réseau formateur d'impulsions (PFN) réalisé selon un circuit à transfert de charge (CH-T), caractérisé par le fait qu'en plus du premier appareil d'alimentation haute tension (A), un second appareil d'alimentation haute tension (A') du même genre, est relié, par l'intermédiaire d'un condensateur accumulateur intermédiaire (C₀') prévu dans une branche transversale et par l'intermédiaire d'un circuit série constitué par l'interrupteur (S₁') et la self amont (L₀') prévue dans une branche longitudinale ainsi que par l'intermédiaire d'une capacité supplémentaire (C₃) prévue dans une branche transversale supplémentaire, à la branche transversale de l'inducteur (LM).

11. Système d'excitation selon la revendication 10, du type dans lequel les interrupteurs (S₁, S₁') qui relient l'appareil d'alimentation haute tension (A, A') au réseau formateur d'impulsions (PFN), sont des interrupteurs électroniques, comme par exemple des Thyratrons, caractérisé par le fait que les interrupteurs (S₁, S₁') sont pourvus de moyens de commande pour leur déclenchement simultané, et que la durée de charge ($t_{L2}$*) de la boucle de charge (LA 2*) qui comporte l'appareil d'alimentation haute tension supplémentaire (A') et qui fournit, pour l'essentiel, le courant de magnétisation de l'inducteur (LM), et la durée de charge ($t_{L1}$*) de la boucle de charge (LA 1*) qui sert à la charge du condensateur à conducteur à ruban (C₁*) et qui comporte le premier appareil d'alimentation haute tension (A₁), sont identiques entre elles, avec, en première approximation:

$$t_{L2^*} = t_{L1^*} = \pi \sqrt{L_0 \cdot \tfrac{C_{1^*} + C_3}{C_0' + C_3}} = \pi \sqrt{L_0 \tfrac{C_{1^*} + C_0}{C_0}}.$$

12. Système d'excitation selon l'une des revendications 10 ou 11, caractérisé par le fait que l'énergie (C₀' · $\tfrac{U^2}{2}$), qui est accumulée dans le condensateur accumulateur intermédiaire (C₀') de la boucle de charge supplémentaire (LA 2*) est choisie pour être supérieure à l'énergie (L₁ · $\tfrac{J^2}{2}$) qui est nécessaire pour la magnétisation de l'inducteur (LM).

13. Système d'excitation selon l'une des revendications 1 à 12, comportant une unité de construction qui est constiuée par la tête de laser et les premier et second condensateurs à conducteur à ruban associés, les condensateurs à conducteur à ruban s'étendant, avec leurs revêtements et leurs couches diélectriques qui se situent entre elles, pour l'essentiel normalement à l'axe optique de la chambre de laser, en étant empilés en un paquet de condensateurs et en étant reliés directement ou à l'aide de languettes de raccordement débordant latéralement, à l'intérieur du réseau formateur d'impulsions, alors que la chambre de laser est disposée sur un côté longitudinal du paquet de condensateurs, caractérisé par le fait que l'inducteur saturable (LM) est disposé sur un autre côté longitudinal du paquet de condensateurs (KP) et que la liaison de commutation de l'enroulement de travail (L₁) de l'inducteur avec les revêtements (b1, b2 et b3*, b2*) des condensateurs à conducteurs à ruban a lieu par l'intermédiaire d'une branche d'amenée de courant (m1) médiane, allongée et parallèle à l'axe du laser tandis que le retour du courant a lieu respectivement par l'intermédiaire d'une branche de retour de courant (m21, m22) située en dehors du milieu, de forme allongée et parallèle à l'axe du laser, étant noté que les branches de retour du courant (m21, m22) s'étendent, largement, de façon bifilaire par rapport à la branche d'amenée du courant (m1) et que dans les espaces creux entre les deux branches de retour du courant (m21, m22), d'une part, et la branche d'amenée du courant (m1), d'autre part, - et avec insertion de couches isolantes intermédiaires -, sont disposées les branches (k) de l'inducteur, qui sont fermées sur elles-mêmes, qui sont constituées par un enroulement d'un matériau en ruban fortement perméable et entourant la branche d'amenée de courant (m1).

14. Système d'excitation selon la revendication 13, du type dans lequel les revêtements de condensateurs à conducteurs à ruban ont une forme rectangulaire alors que le paquet de condensateurs a la forme d'un parallélépipède, caractérisé par le fait que l'inducteur saturable est disposé sur le côté longitudinal du paquet de condensateurs qui se situe en face de la tête de laser (LA).

15. Système d'excitation selon la revendication 13 ou 14, avec un inducteur comportant un enroulement de commande, caractérisé par le fait que les spires de l'enroulement de commande (M) entourent les branches (k) du noyau, qui sont fermées sur elles-mêmes, de l'inducteur, sur une partie de boucle, débordante, des branches du noyau et/ou passent à travers la branche d'amenée du courant (m1) et sont renvoyées, en dehors des branches (k) du noyau, vers l'alimentation en courant de commande.

16. Système d'excitation selon la revendication 2, caractérisé par le fait que le circuit selon la revendication 4 est modifié, par inversion du condensateur accumulateur intermédiaire (C₀) et du circuit série constitué par l'interrupteur (S₁) et par la self amont (L₀), de telle façon que l'interrupteur (S₁) est porté, par une borne, au potentiel terre et que le circuit série constitué par (C₀, L₀ et S₁) est monté en parallèle sur l'inducteur (L₁) et, de façon correspondante, parallèlement au premier condensateur à conducteurs à ruban (C₁), et qu'à l'intérieur de la seconde boucle de charge (LA 2), le circuit série constitué par l'interrupteur (S₁') et par la bobine amont (L₀') est transféré de la branche longitudinale "supérieure" qui est portée au potentiel positif, à la branche longitudinale "inférieure" qui est reliée à la masse par l'intermédiaire de l'impédance (R) qui est montée en parallèle sur le laser, et cela de telle manière, que de façon correspondante la suite des éléments de commutation (S₁ - L₀ - C₀ - C₁ - S₁) de la première boucle de charge (LA 1), il en résulte la suite des éléments de commutation (S₁' - L₀' - C₀' - C₂ - S₁') de la seconde boucle de charge (LA 2).

17. Système d'excitation selon l'une des revendications 4, 5, 10 ou 16, caractérisé par le fait que l'impédance qui est montée en parallèle sur la chambre de laser (LK), est une impédance fortement ohmique, en particulier une résistance fortement ohmique (R) comparativement à la self $(L_3)$.

82 P 6069

FIG 1

FIG 2

FIG 3

82 P 6069

FIG 4

FIG 5

3

82 P 6069

FIG 6

FIG 7

5

82 P 6069

FIG 8

FIG 9

7